# EUROPEAN PATENT APPLICATION

(11) **EP 2 437 302 A2**
(43) Date of publication of application: **04.04.2012**
(21) Application number: 11183285.3
(22) Date of filing: 29.09.2011
(51) Int. Cl.: H01L 27/30, H01L 51/42

(54) **Photoelectric converter, method of manufacturing photoelectric converter and imaging device**

(30) Priority: 30.09.2010 JP 2010223277; 28.04.2011 JP 2011102256
(71) Applicant: Fujifilm Corporation, Minato-ku Tokyo (JP)
(72) Inventor: Nakatani, Toshihiro, Kanagawa (JP); Goto, Takashi, Kanagawa (JP); Morita, Yoshiki, Kanagawa (JP); Imai, Shinji, Kanagawa (JP); Suzuki, Hideyuki, Kanagawa (JP); Sawaki, Daigo, Kanagawa (JP)
(74) Representative: Klunker . Schmitt-Nilson . Hirsch

(57) **Abstract**

A photoelectric converter includes a pair of electrodes and a plurality of organic layers. The pair of electrodes is provided above a substrate. The plurality of organic layers is interposed between the pair of electrodes and includes a photoelectric conversion layer and a given organic layer being formed on one electrode of the pair of electrodes. The one electrode is one of pixel electrodes arranged two-dimensionally. The given organic layer has a concave portion that is formed in a corresponding position located above a step portion among the arranged pixel electrodes. An angle θ of the concave portion is less than 50 °, where an inclination angle of a tangent plane at a given point on the concave portion to a surface plane of the substrate is defined as θ.

## Description

### BACKGROUND

### 1. Technical Field

The present invention relates to a photoelectric converter, a method of manufacturing a photoelectric converter, and an imaging device.

### 2. Related Art

In the related art, the laminated type photoelectric converter equipped with a pair of electrodes and a photoelectric conversion layer disposed between a pair of electrodes on a substrate has already been known. Also, the imaging device equipped with this photoelectric converter has already been known. As the laminated type photoelectric converter, there is the photoelectric converter shown in JP-2007-273555.

In JP-A-2007-273555, the photoelectric converter in which a plurality of pixel electrodes, a photoelectric conversion layer, and an opposing electrode are formed in this sequence over a substrate is set forth.

In the laminated type photoelectric converter, in some cases a crack occurs in the photoelectric conversion layer. Then, in the imaging device including the photoelectric converter, the noise such as the white defect, or the like is increased when a dark image is taken.

As the cause of occurrence of the crack, it may be thought that a step portion formed at the end portion of the pixel electrode has an influence upon such occurrence of the crack.

Upon manufacturing the laminated type photoelectric converter, a plurality of pixel electrodes are formed over the substrate. At this time, a steep step portion is formed at the end portion in each pixel electrode. Then, a plurality of organic layers each containing the photoelectric conversion layer are vapor-deposited sequentially on a plurality of pixel electrodes, and then an opposing electrode made of ITO, or the like is formed over a plurality of organic layers. In the photoelectric converter manufactured in this manner, a concave portion that becomes depressed to follow the shape of such step portion is formed on respective organic layers that are vapor-deposited over the pixel electrodes respectively. Then, in some cases the cracks may occur all over a plurality of organic layers in such photoelectric converter. The occurred cracks are concentrated above the step portions of the pixel electrodes. For this reason, it may be thought that a leakage current is generated in the portion of the organic layer where the crack occurs, and thus the noise is generated in such portion.

Also, the opposing electrode has a shape to follow the concave portion in the organic layer that is formed just under this electrode, so that its shape becomes depressed partially in the underlying organic layer. At that time, a possibility of a short circuit between the depressed part of the opposing electrode and the pixel electrode may increase, and as a result the noise in signal (referred to as an "dark signal" hereinafter) which is obtained when any light do not incident into the photoelectric converter may increase.

The photoelectric converter in JP-2007-273555 is equipped with an unevenness lessening layer used to lessen an unevenness on the surface of the electrode is provided between the photoelectric conversion layer and one electrode out of a pair of electrodes consisting of the upper electrode and the lower electrode. According to this photoelectric converter, since the influence of minute unevennesses on the surface of the electrode upon the photoelectric conversion layer is reduced by the unevenness lessening layer, occurrence of the crack is suppressed. However, the measure for suppressing the occurrence of the crack caused by a step portion of the pixel electrode is not set forth therein.

The present invention provides a photoelectric converter, a method of manufacturing a photoelectric converter, and an imaging device, which are capable of suppressing a crack caused by a step portion formed at end portions of a pixel electrode, and thus capable of reducing a noise.

### SUMMARY OF INVENTION

According to an aspect of the invention, a photoelectric converter includes a pair of electrodes and a plurality of organic layers. The pair of electrodes is provided above a substrate. The plurality of organic layers is interposed between the pair of electrodes and includes a photoelectric conversion layer and a given organic layer being formed on one electrode of the pair of electrodes. The one electrode is one of pixel electrodes arranged two-dimensionally The given organic layer has a concave portion that is formed in a corresponding position located above a step portion among the arranged pixel electrodes. An angle θ of the concave portion is less than 50 °, where an inclination angle of a tangent plane at a given point on the concave portion to a surface plane of the substrate is defined as θ.

According to another aspect of the invention, a method of manufacturing a photoelectric converter that includes a pair of electrodes that is provided above a substrate and a plurality of organic layers that is interposed between the pair of electrodes and includes a photoelectric conversion layer and a given organic layer being formed on one electrode of the pair of electrodes, the one electrode is one of pixel electrodes arranged two-dimensionally. The method includes first to third forming step and an annealing step. In the first forming step, an insulating layer is formed on the substrate. In the second forming step, a pattern of the plurality of pixel electrodes is formed on the insulating layer. In the third forming step, the organic layer is formed to cover the plurality of pixel electrodes. In the annealing step, the organic layer is annealed by applying heating such that a shape of the concave portion formed on the organic layer in a corresponding position located above a step portion among the pixel electrodes is made smooth, before another organic layer is formed on the organic layer.

According to the present invention, the photoelectric converter that is capable of suppressing occurrence of the crack and reducing the noise caused by the crack, and the method of manufacturing the photoelectric converter is provided.

### BRIEF DESCRIPTION OF THE DRAWINGS

FIG.1 is a view schematically showing a section of an imaging device.
FIG.2 is a view explaining a step portion in a gap between the imaging devices and a structure of a first organic layer in FIG.1.
FIGS.3A to 3C are views explaining procedures in a method of manufacturing a photoelectric converter.
FIG.4 is a schematic sectional view showing shapes of a step portion between pixel electrodes and a concave portion of the first organic layer in the photoelectric converter.
FIG.5 is a graph showing a relation between an inclination angle θ2 and a rate of the number of white defect pixels.
FIG6 is a graph showing a relation between a molecular weight and an inclination angle θ2.
FIG.7 is a graph showing a relation between a molecular weight and a rate of the number of white defect pixels.
FIG.8 is a graph showing a detailed change in a rate of the number of white defect pixels within a range of a molecular weight of more than 500 but less than 1300.
FIG.9 is a graph showing a relation between an annealing temperature and an inclination angle θ2.
FIG.10 is a graph showing a relation between an annealing temperature and a rate of the number of white defect pixels.
FIG.11 is a graph showing a relation between a substrate temperature and an inclination angle θ2.
FIG.12 is a graph showing a relation between a substrate temperature and a rate of the number of white defect pixels.
FIG.13 is a sectional view showing an example of a configuration of the imaging device.

### DETAILED DESCRIPTION

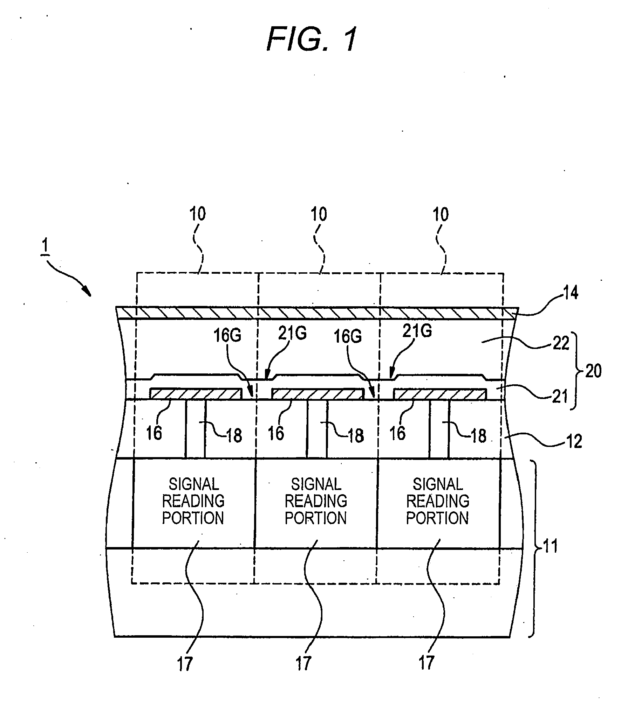

FIG.1 is a view showing schematically a section of an imaging device to explain an embodiment of the present invention. An imaging device 1 includes a substrate 11, an insulating layer 12, an intermediate layer 20, an opposing electrode 14, a plurality of pixel electrodes 16, connection portions 18, and signal reading portions 17.

The substrate 11 is formed of a glass substrate or a semiconductor substrate made of silicon, or the like. The insulating layer 12 is formed on the substrate 11. A plurality of pixel electrodes 16 are formed on the insulating layer 12.

A plurality of pixel electrodes 16 are arranged at a predetermined interval two-dimensionally in the horizontal direction of a surface of the insulating layer 12 and the vertical direction that intersects orthogonally with this horizontal direction.

The intermediate layer 20 is formed by stacking a first organic layer 21 and a second organic layer 22. The first organic layer 21 acts as an electron blocking layer, and is provided to cover the pixel electrodes 16. The second organic layer 22 acts as a photoelectric conversion layer formed of the organic photoelectric conversion material that generates electric charges in response to a received light. Here, the intermediate layer 20 is not restricted to the configuration consisting of two organic layers 21, 22. If such intermediate layer is constructed by a plurality of organic layers containing at least the photoelectric conversion layer, any configuration may be employed.

The opposing electrode 14 acts as the electrode that opposes to respective pixel electrodes 16, and is provided on the intermediate layer 20. The opposing electrode 14 is formed of the conductive material that is transparent to an incident light such that the light can be transmitted to the intermediate layer 20. The opposing electrode 14 is constructed such that a predetermined voltage is applied to the opposing electrode 14 via wirings (not shown). Accordingly, an electric field is applied between the opposing electrode 14 and a plurality of pixel electrodes 16. Here, for the advantage of the present invention, it is preferable that a predetermined voltage is set within a range of -30 V to 30 V.

A pair of electrodes including each pixel electrode 16 and the opposing electrode 14 located over the pixel electrodes 16 and the first organic layer 21 and the second organic layer 22 arranged between both the pixel electrode 16 and the opposing electrode 14 act as the photoelectric converter.

The imaging device 1 has pixel portions 10 that are arranged in an array fashion. The pixel portion 10 is defined as one of blocks that are partitioned by a broken line shown in FIG.1 respectively. The pixel portion 10 contains the photoelectric converter.

The pixel electrode 16 acts as the electric charge collecting electrode. This electric charge collecting electrode collects electric charges generated in the photoelectric conversion layer in the intermediate layer 20 contained in the pixel portion 10. The signal reading portion 17 is provided so as to correspond to each of a plurality of pixel electrodes 16, and outputs the signal that corresponds to the electric charges collected by the corresponding pixel electrode 16. The signal reading portion 17 may includes a CCD, a MOS transistor circuit (MOS circuit), a TFT circuit, or the like, for example. The connection portion 18 electrically connects the pixel electrode 16 and the signal reading portion 17 corresponding to the pixel electrode 16, and is buried in the insulating layer 12. The connection portion 18 is formed of the conductive material such as tungsten (W), or the like.

For example, when the signal reading portion 17 is the MOS circuit, this signal reading portion includes a floating diffusion, a reset transistor, an output transistor, and a selection transistor (all not shown). Each of the reset transistor, the output transistor, and the selection transistor is made of an n-channel MOS transistor (referred to as an "nMOS transistor" hereinafter).

The signal reading portion 17 reads the signal that corresponds to the electric charges collected by the pixel electrode 16 by using such circuit configuration.

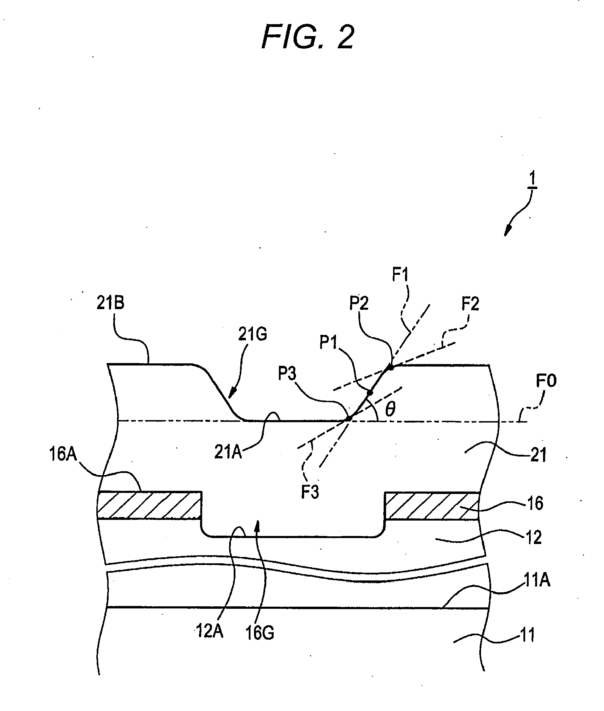

FIG2 is a view explaining a relation between a step portion in a gap between the pixel electrodes 16 and the first organic layer in FIG.1. The electrodes 16 having a predetermined pattern are formed on the insulating layer 12 by the vacuum deposition method (e.g., the sputtering), etching via a mask. At this time, when a part of the pixel electrodes 16 are removed by the etching, a surface 12A of the insulating layer 12which is an underlying layer of the pixel electrodes 16 appears between the pixel electrodes 16. Also, step portions 16G is formed at each end portion of a plurality of pixel electrodes 16 between a surface 16A of the pixel electrode 16 and the surface 12A of the insulating layer 12. This step portion 16G is also referred to as a "step portion 16G among the pixel electrodes 16". Here, a bottom surface 12A of the concave portion that is surrounded by the step portion 16G corresponds to a surface of the insulating layer 12. The bottom surface 12A is located deeper than the surface of the part of the insulating layer 12 which contacts the bottom surface of the pixel electrode 16. This is because the insulating layer 12 is over-etched when the pixel electrodes 16 are patterned.

Here, for the advantage of the present invention, it is preferable that a size of the pixel electrode 16 is set to 3 µm or less. More preferably, this size is set to 2 µm or less. Further preferably, this size is set to 1.5 µm or less. Also, for the advantage of the present invention, it is preferable that a gap between the pixel electrodes 16 is set to 0.3 µm or less. More preferably, this gap is set to 0.25 µm or less. Further preferably, this gap is set to 0.2 µm or less.

An area corresponding to the concave portion between the pixel electrodes 16 is relatively increased larger as a pixel size is decreased smaller, so that the advantage of the present invention becomes conspicuous. Also, the film formation of the first organic layer 21, as described later, becomes more uneven as the gap between the pixel electrodes 16 made smaller, so that the advantage of the present invention becomes conspicuous.

The first organic layer 21 is formed so as to cover a plurality of pixel electrodes 16 and respective step portions 16G between the pixel electrodes 16. The first organic layer 21 is formed by the vapor deposition. Surface profiles of a plurality of pixel electrodes 16 and the step portions 16G between the pixel electrodes 16 are reflected on the surface of the first organic layer 21 respectively, and then a concave portion 21G is formed in the corresponding positions located over the step portions 16G respectively. The concave portion 21G of the first organic layer 21 becomes depressed from the surface 21B of the first organic layer 21 toward the step portion 16G formed between the pixel electrodes 16. A bottom portion 21A of the concave portion 21G and a surface 21B of remaining part of the first organic layer 21 are joined together by an inclined surface.

Normally, when the first organic layer 21 is formed on a plurality of pixel electrodes 16 which are patterned, there is such a tendency that an inclination of the inclined surface is increased by the influence of the corresponding step portion 16G. In this imaging device, after this first organic layer 21 is formed by the vapor deposition, a post-treatment is applied to the first organic layer 21 so as to make the concave portion 21 G more smooth. This post-treatment will be described later.

Here, smoothness of the concave portion 21 G on the first organic layer 21 is expressed by an inclination angle, to the surface of the substrate 11, of a tangential plane at a given point on the surface of the concave portion 21G In FIG.2, for example, the given points on the surface of the concave portion 2 1 G of the first organic layer 21 are indicated with P1, P2, and P3. Also, a tangential plane at the point P 1 is indicated with F1, a tangential plane at the point P2 is indicated with F2, and a tangential plane at the point P3 is indicated with F3. Further, a surface 11A of the substrate 11 of the imaging device 1 is defined as the reference surface that is used to show an inclination angle of the tangential plane. A line F0 in FIG.2 is depicted to explain an inclination angle, and illustrates a virtual surface that is parallel to the surface 11A of the substrate 11.

In FIG.2, an inclination angle of the tangential plane F1 at the point P1 in the concave portion 21G of the first organic layer 21 to the line F0 is denoted by θ. Also, the tangential plane at the point P1 has the largest inclination angle to the line F0, in contrast to the tangential planes at other points P2, P3. At this time, when an inclination angle θ becomes smaller, a profile of the concave portion 21 G of the first organic layer 21 becomes smooth. This means that the first organic layer 21 is formed to come closer to the flat surface. In the solid state imaging device 1, the noise in the dark signal is reduced when this inclination angle θ is decreased less than 50°. The reason for this will be given as follows. When a shape of the concave portion 21G of the first organic layer 21 is made smooth in the solid-state imaging device, the concave portion is not formed on the second organic layer 22 formed on the first organic layer 21. Even if such concave portion is formed on the second organic layer 22, a shape of the concave portion on the second organic layer 22 becomes smooth. Then, occurrence of the crack is suppressed in the first organic layer 21 and the second organic layer 22 constituting the intermediate layer 20. As a result, when the image using the dark signal of the solid-state imaging device 1 is displayed, the noise such as the white defect or the like is reduced.

Since a shape of the concave portion formed on the surface of the second organic layer 22 on the opposing electrode 14 side becomes smooth, it can be suppressed that a part of the opposing electrode 14 becomes depressed into the second organic layer. As a result, a short circuit between the opposing electrode 14 and the pixel electrode 16 may be suppressed, and also the noise on a signal obtained by taking a given image can be reduced.

Next, the intermediate layer 20, the pixel electrode 16, and the opposing electrode 14 will be explained hereunder.

The first organic layer 21 out of the intermediate layer 20 acts as the electron blocking layer. This electron blocking layer has a function of suppressing a dark current by suppressing such an event that, when a voltage is applied between the pixel electrode 16 and the opposing electrode 14, the electrons are transported to the pixel electrode 16 which is the hole collecting electrode.

The second organic layer 22 of the intermediate layer 20 acts as the photoelectric conversion layer. This photoelectric conversion layer contains a p-type organic semiconductor and an n-type organic semiconductor. Exciton dissociation efficiency may be enhanced by joining the p-type organic semiconductor and the n-type organic semiconductor to form a donor-acceptor boundary. Therefore, the photoelectric conversion layer made by joining the p-type organic semiconductor and the n-type organic semiconductor has high photoelectric conversion efficiency. In particular, in order to increase the junction boundary to improve the photoelectric conversion efficiency, the photoelectric conversion layer in which the p-type organic semiconductor and the n-type organic semiconductor are mixed is preferable.

The p-type organic semiconductor (compound) corresponds to an electron donative organic semiconductor. This p-type organic semiconductor is typified mainly by a hole transporting organic compound, and denotes the organic compound that has the property of donating the electron easily. In more detail, this p-type organic semiconductor denotes the organic compound whose ionization potential is smaller in such a situation that two organic materials are used in contact with each other. Therefore, any organic compound may be employed as the electron donative organic compound if such organic compound has the electron donating property. For example, a metal complex that has triallylamine compound, benzidine compound, pyrazoline compound, styrylamine compound, hydrazone compound, triphenylmethane compound, carbazole compound, polysilane compound, thiophene compound, phthalocyanine compound, cyanine compound, merocyanine compound, oxonol compound, polyamine compound, indole compound, pyrrole compound, pyrazole compound, polyallylene compound, condensed aromatic carbon ring compound (naphthalene derivative, anthracene derivative, phenanthrene derivative, tetracene derivative, pyrene derivative, perylene derivative, fluoranthene derivative), or nitrogenated heterocycle compound, as a ligand, and the like can be listed. Here, the organic compound is not restricted to the above-mentioned organic compounds. As described above, any organic compound may be employed as the electron donative organic semiconductor if such organic compound has the ionization potential that is smaller than the organic compound used as the n-type (electron acceptive) compound.

The n-type organic semiconductor (compound) corresponds to an electron acceptive organic semiconductor. This n-type organic semiconductor is typified mainly by an electron transporting organic compound, and denotes the organic compound that has the property of accepting the electron easily. In more detail, this n-type organic semiconductor denotes the organic compound whose electron affinity is larger in such a situation that two organic materials are used in contact with each other. Therefore, any organic compound may be used as the electron acceptive organic compound if such organic compound has the electron accepting property. For example, a metal complex that has condensed aromatic carbon ring compound (naphthalene derivative, anthracene derivative, phenanthrene derivative, tetracene derivative, pyrene derivative, perylene derivative, fluoranthene derivative), five to seven-membered heterocycle compound containing nitrogen atom, oxygen atom, and sulfur atom (e.g., pyridine, pyrazine, pyrimidine, pyridazine, triazine, quinoline, quinoxaline, quinazoline, phthalazine, cinnoline, isoquinoline, pteridine, acridine, phenazine, phenanthroline, tetrazole, pyrazole, imidazole, thiazole, oxazole, indazole, benzimidazole, benzotriazole, benzooxazole, benzothiazole, carbazole, purine, triazopyridazine, triazopyrimidine, tetrazaindene, oxadiazole, imidazopyrizine, pyrazine, pyrropyridine, thiadiazolopiridine, dibenzazepine, tribenzazepine, etc.), polyallylene compound, fluorene compound, cyclopentadiene compound, silyl compound, or nitrogenated heterocycle compound, as a ligand, and the like can be listed. Here, the organic compound is not restricted to the above. As described above, any organic compound may be employed as the electron acceptive organic semiconductor if such organic compound has the electron affinity that is larger than the organic compound used as the p-type (electron donative) compound.

As the p-type organic semiconductor or the n-type organic semiconductor, any organic pigment may be employed. It is preferable that cyanine pigment, styryl pigment, hemicyanine pigment, merocyanine pigment (containing zeromethine merocyanine (simple merocyanine)), trinuclear merocyanine pigment, tetranuclear merocyanine pigment, rhodacyanine pigment, complex cyanine pigment, complex merocyanine pigment, allopolar pigment, oxonol pigment, hemioxonole pigment, squalium pigment, chroconium pigment, azamethine pigment, coumalin pigment, allylidene pigment, anthraquinone pigment, triphenylmethane pigment, azo pigment, azomethine pigment, spiro compound, metallocene pigment, fluorenone pigment, fulgide pigment, perylene pigment, perinone pigment, phenazine pigment, phenothiazine pigment, quinone pigment, diphenylmethane pigment, polyene pigment, acridine pigment, acridinone pigment, diphenylamine pigment, quinacridone pigment, quinophthalone pigment, phenoxazine pigment, phthaloperylene pigment, diketopyrropyrrole pigment, dioxane pigment, porphyrin pigment, chlorophyll pigment, phthalocyanine pigment, metal complex pigment, and condensed aromatic carbon ring pigment (naphthalene derivative, anthracene derivative, phenanthrene derivative, tetracene derivative, pyrene derivative, perylene derivative, fluoranthene derivative) may be listed.

It is particularly preferable that fullerene or fullerene derivative, which is excellent in the electron transportation property, should be employed as the n-type organic semiconductor. The fullerene denotes fullerene c60, fullerene c70, fullerene c76, fullerene c78, fullerene c80, fullerene c82, fullerene c84, fullerene c90, fullerene c96, fullerene c240, fullerene c540, mixed fullerene, and fullerene nanotube. The fullerene derivative denotes a compound in which a substituent is added to them.

As the substituent of the fullerene derivative, preferably there is alkyl group, allyl group, or heterocycle group. As the alkyl group, preferably there is alkyl group whose carbon number ranges from 1 to 12. As the allyl group and the heterocycle group, preferably there is benzene ring, naphthalene ring, anthracene ring, phenanthrene ring, fluorene ring, triphenylene ring, naphthacene ring, biphenyl ring, pyrrole ring, furan ring, thiophene ring, imidazole ring, oxazole ring, thiazole ring, pyridine ring, pyrazine ring, pyrimidine ring, pyridazine ring, indolizine ring, indole ring, benzofuran ring, benzothiophene ring, isobenzofuran ring, benzimidazole ring, imidazopyridine ring, quinolizine ring, quinoline ring, phthalazine ring, naphthyridine ring, quinoxaline ring, quinoxazoline ring, isoquinoline ring, carbazole ring, phenanthridine ring, acridine ring, phenanthroline ring, thianthrene ring, chromene ring, xanthene ring, phenoxathiin ring, phenothiazine ring, or phenazine ring. More preferably, there is benzene ring, naphthalene ring, anthoracene ring, phenanthrene ring, pyridine ring, imidazole ring, oxazole ring, or thiazole ring. Particularly preferably, there is benzene ring, naphthalene ring, or pyridine ring. Each of these rings may have further substituents, and the substituents may be bonded as far as possible to form a ring. Further, each of these rings may have a plurality of substituents, and the same substituents or the different substituents may be employed herein. Also, a plurality of substituents may be bonded as far as possible to form a ring.

Since the photoelectric conversion layer contains the fullerene or the fullerene derivative, the electrons produced by the photoelectric conversion can be quickly transported to the pixel electrode 16 or the opposing electrode 14 via fullerene molecules or fullerene derivative molecules. When paths of the electrons are formed in such a condition that the fullerene molecules or the fullerene derivative molecules are linked to each other, the electron transporting property can be improved and thus quick responsivity of the photoelectric conversion layer can be implemented. For this reason, it is preferable that the fullerene molecules or the fullerene derivative molecules should be contained in excess of 40 % in the photoelectric conversion layer. In this event, when a rate of the fullerene or the fullerene derivative is increased too much, a rate of the p-type organic semiconductor is reduced and also the junction boundary is reduced, so that the exciton dissociation efficiency is decreased.

As p-type organic semiconductor that is mixed together with the fullerene or the fullerene derivative in the photoelectric conversion layer, it is particularly preferable that triallylamine compound, as set forth in Japanese Patent No.4213832, should be employed because a high S/N ratio of the photoelectric conversion layer can be implemented. When a ratio of the fullerene or the fullerene derivative in the photoelectric conversion layer is set excessively large, the triallylamine compound is decreased and thus an absorption amount of an incident light is decreased. According to this, the photoelectric conversion efficiency is decreased. Therefore, it is preferable that the fullerene or the fullerene derivative contained in the photoelectric conversion layer should be set to a composition of less than 85 %.

As the electron blocking layer, the organic material having the electron donating property can be employed. Also, it is preferable that the small molecule material suitable for the physical vapor deposition method should be employed as such organic material. Concretely, in the small molecule material, aromatic diamine compound such as N,N'-bis(3-methyl phenyl)-(1,1'-biphenyl)-4,4'-diamine (TPD), 4,4'-bis[N-(naphthyl)-N-phenyl-amine]biphenyl (α-NPD), or the like, oxazole, oxadiazole, triazole, imidazole, imidazolon, stilbene derivative, pyrazolin derivative, tetrahydroimidazole, polyarylalkane, butadiene, 4,4',4"- tris(N-(3-methyl phenyl)N-phenylamino)triphenylamine (m-MTDATA), porphin, tetraphenylporphin copper, phthalocyanine, copper phthalocyanine, porphyrin compound such as titanium phthalocyanine oxide, or the like, triazole derivative, oxadiazole derivative, imidazole derivative, polyarylalkane derivative, pyrazolin derivative, pyrazolone derivative, phenylenediamine derivative, anilamine derivative, amino substitution chalcone derivative, oxazole derivative, styrylanthracene derivative, fluorenone derivative, hydrazone derivative, silazane derivative, and the like can be employed. In the polymer material, the polymer such as phenylenevinylene, fluorene, carbazole, indole, pyrene, pyrrole, picoline, thiophene, acetylene, diacetylene, and the like, and also their derivatives can be employed. Even though the compound is not always the compound with the electron donating property, any compound may be employed if such compound has the enough hole transportation property. Particularly, a following structure out of the organic materials with the electron donating property is preferable. Where R1, R2, R3 denote a substituent, an atomic group, or an atom, and they may be condensed mutually to constitute a ring.

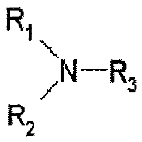

A plurality of pixel electrodes 16 collect electric charges of holes, which are generated in the intermediate layer 20 containing the photoelectric conversion layer on each pixel electrode 16. The electric charges being collected by each pixel electrode 16 are read as the signal by the signal reading portion 17 of the corresponding pixel portion 10. Then, the image is synthesized based on the signals obtained from a plurality of pixel portions.

The opposing electrode 14, together with the pixel electrode 16, is formed to put the intermediate layer 20 including the photoelectric conversion layer between them, so that this opposing electrode 14 applies an electric field to the intermediate layer 20, and then the pixel electrode 16 collects the electrons out of the electric charges generated by the photoelectric conversion layer. The opposing electrode 14 is merely requested to collect the electric charges of opposite polarity with respect to the electric charges that the pixel electrode 16 collects, and it is not needed that the opposing electrode 14 is divided every pixel portion 10. Therefore, the opposing electrode 14 may be formed as the electrode that is common to a plurality of pixels. As a result, sometimes the opposing electrode 14 is also called the common electrode.

It is preferable that the opposing electrode 14 should be formed of a transparent conductive film because this electrode has to input a light into the intermediate layer 20 including the photoelectric conversion layer. For example, as such transparent conductive film, metal, metallic oxide, metallic nitride, metallic boride, organic conductive compound, etc., and their mixture may be used. As the concrete example, conductive metallic oxide such as tin oxide, zinc oxide, indium oxide, indium tin oxide (ITO), indium zinc oxide (IZO), indium tungsten oxide (IWO), titanium oxide, or the like; metallic nitride such as TiN, or the like; metal such as gold (Au), platinum (Pt), silver (Ag), chromium (Cr), nickel (Ni), aluminum (A1), or the like; mixtures or laminates formed of these metals and the conductive metallic oxide; organic conductive compound such as polyaniline, polythionphene, polypyrrole, or the like and laminates formed of these compounds and ITO, and the like may be listed. As the material of the transparent conductive film, any one of ITO, IZO, tin oxide, antimony-doped zinc oxide (ATO), fluorine-doped tin oxide (FTO), zinc oxide, antimony- doped zinc oxide (AZO), and gallium-doped zinc oxide (GZO) is particularly preferable.

In the case where the signal reading portion 17 is of the CMOS type, a sheet resistance of the opposing electrode 14 is set preferably to 10 KΩ/□ or less, and more preferably to 1 KΩ/□ or less. In the case where the signal reading portion 17 is of the CCD type, the sheet resistance is set preferably to 1 kΩ/□ or less, and more preferably to 0.1 KΩ/□ or less.

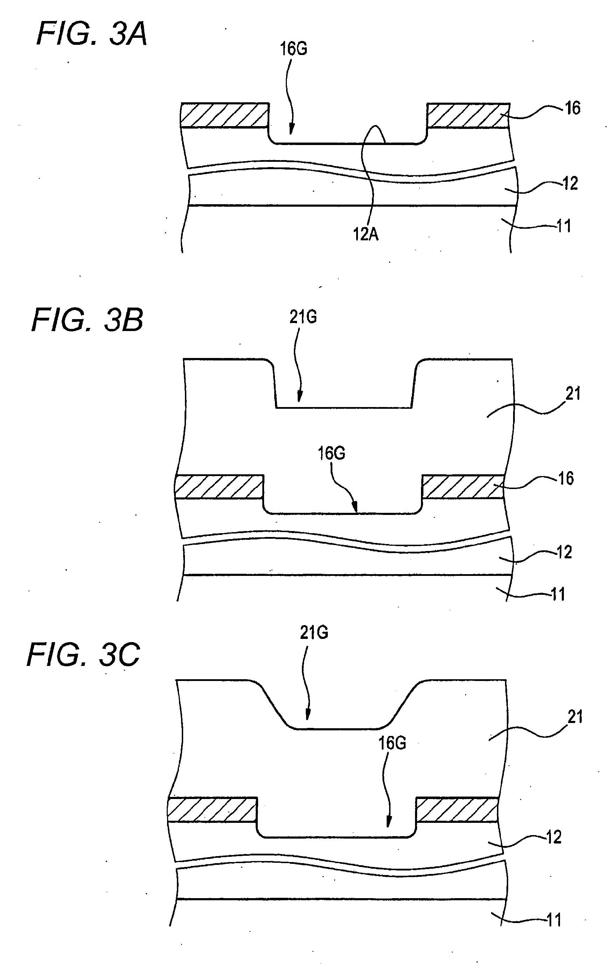

Next, a method of manufacturing the photoelectric converter will be explained hereunder. FIGS.3A-3C are sectional views showing a part of procedures of manufacturing the photoelectric converter. A configuration of the photoelectric converter is similar to that shown in FIG.1. The explanation of the configuration of the photoelectric converter given in the following will be simplified or omitted by referring appropriately to the reference numerals in FIG.1.

First, the signal reading portions 17 are formed in the substrate 11 such as a silicon substrate, or the like by using the general-purpose semiconductor manufacturing steps. Then, the insulating layer 12 is formed on the surface of the substrate 11 on the light-incident side, and then the surface of the insulating layer 12 is polished and planarized by the CMP, or the like. Then, holes each used to form the connection portion 18 are formed in the insulating layer 12 by the photolithography step and/or the dry etching step. The holes are formed in portions that are located under the area in which the pixel electrode 16 is formed in the insulating layer 12, respectively. The connection portion 18 is formed in the formed holes respectively by using the conductive material.

The material of the pixel electrode 16 is formed as a film on the insulating layer 12 by the chemical vapor deposition (CVD) method, or the like. Then, this film is patterned by the photolithography step and the dry etching step, which are utilized in the normal multilayer wiring technology, so that the pixel electrode portions are arranged at a predetermined interval. In this manner, as shown in FIG.3A, a plurality of pixel electrodes 16 are formed on the insulating layer 12. The step portion 16G is formed between the pixel electrode and the other pixel electrode adjacent thereto.. In the case of this manufacturing method, the step portions 16G may be formed as a step portion with a steep angle of inclination. Even under such situation, the photoelectric converter and the imaging device, which generate less noise, may be manufactured by the manufacturing method of the present invention.

When an inclination angle θ1 of the step portion 16G is 50°<θ1≤90°, the advantages of the present invention become conspicuous. When the angle θ1 becomes larger than 50 °, events described later become more conspicuous. The event may include an occurrence of the crack in the first organic layer 21 and the second organic layer 22 and an occurrence of the depressing of a part of the opposing electrode 14 into the second organic layer 22. When the angle θ1 is in excess of 90 °, the portions that are not subjected to the deposition due to end portions of the pixel electrodes are increased. In this case, it becomes difficult to make the step portion 16G smooth.

Then, as shown in FIG3B, the first organic layer 21 is vapor-deposited so as to cover a plurality of pixel electrodes 16 and the step portions 16G located between these electrodes. The physical vapor deposition (PVD) method is employed to vapor-deposit the first organic layer 21, and the vacuum thermal evaporation deposition method, etc., for example, is employed. The concave portion 21G is formed on the vapor- deposited first organic layer 21 in the corresponding positions that are located over the step portions 16G between the pixel electrodes 16. At this time, the concave portion 21G formed on the first organic layer 21 has a shape to reflect a shape of the step portion 16G between the pixel electrodes 16. More particularly, a depth of the concave portion 21G is increased deeper as a depth of the step portions 16G becomes larger, and a width of the concave portion 21G (a dimension in the lateral direction in FIGS.3A-3C) is increased wider as a width of the step portions 16G becomes larger.

After the first organic layer 21 is vapor-deposited, the annealing process is applied. This annealing process is applied in such a manner that the first organic layer 21 is exposed to a high temperature atmosphere and is heated to render a shape of the concave portion 21G smooth. Then, as shown in FIG.3C, a shape of the concave portion 21G formed on the first organic layer 21 becomes smooth by the annealing process.

Then, desirable conditions of the first organic layer 21 applied when this layer is subjected to the annealing process will be explained hereunder.

As the material of the first organic layer 21, small molecule material that is suitable for the physical vapor deposition and has a molecular weight of 550 to 1250 is desirable. More preferably, the material has a molecular weight of 630 to 1150. When a molecular weight is below 550, the material tends to crystallize and thus a shape of the concave portion 21G is hard to become smooth. Also, when a molecular weight is increased more than 1250, the molecules are difficult to move. In that case, it is difficult a shape of the concave portion 21G becomes smooth.

It is preferable that the first organic layer 21 that is subjected to the annealing process is the electric charge blocking layer (in the example in FIGS.3A-3C, the electron blocking layer). In the case that the organic layer formed of the photoelectric conversion material is subjected to the annealing process, since a performance change such as a remarkable degradation of a photoelectric converting function, particularly a response speed to a light, or the like is increased by the annealing, it becomes difficult to control such organic layer formed of the photoelectric conversion material. It is preferable that the electron blocking layer, described in detail later, is employed for the advantages of the present invention.

It is preferable that a thickness of the first organic layer 21 is set to exceed a depth D1 of the step portion 16G. When a thickness of the first organic layer 21 is below the depth D1 of the step portion 16G, a shape of the concave portion 21G is hard to become smooth. Preferably, a thickness of the first organic layer 21 is set to D1×1.2 or more, and more preferably to D1×1.4 or more.

Then, desirable conditions of the annealing process will be explained hereunder.

It is preferable that a temperature at which the first organic layer 21 is annealed is set to less than a glass transition temperature (Tg) of the material of the first organic layer 21. When the first organic layer 21 is annealed at a temperature in excess of Tg, the first organic layer 21 is formed to constitute an uneven film. As a result, the essential photoelectric conversion characteristic as the photoelectric converter is not obtained.

When the first organic layer 21 is annealed at the temperature that is less than Tg but is close to Tg, a shape of the concave portion 21 G may be made smooth.

Preferably, the annealing temperature is set to Tg×0.72 or more but Tg or less. More preferably, the annealing temperature is set to Tg×0.75 or more but Tg or less.

Here, in the measurement of Tg, a probe is positioned on the deposition film (film thickness 100 nm) formed of the material of the first organic layer 21 on a glass plate, then this probe is heated up to 300 °C from a room temperature at a temperature rising rate of 10 °C/s by using the local heating system "nano-TA2" manufactured by Anasys Instruments, and then a point of inflection detected due to the softening penetration is decided as a glass transition temperature.

After the annealing process is applied to the first organic layer 21, the second organic layer 22 is similarly formed on the first organic layer 21 by the vapor deposition, and then the opposing electrode 14 is formed. Further, a buffer layer, a passivation layer, a sealing assisting layer, a color filter, and an overcoat layer, which are described later, are formed on the opposing electrode 14. Methods and procedures of forming these members and these layers are not particularly restricted.

According to the above-mentioned manufacturing method, after the first organic layer 21 is vapor-deposited to cover a plurality of pixel electrodes 16, this first organic layer 21 is annealed by the heating such that a shape of the concave portion 21G is made smooth. By doing this, in the manufactured solid state imaging device, a shape of the concave portion 21G of the first organic layer 21 becomes smooth, and thus the concave portion of the second organic layer 22 formed on the first organic layer 21 is not formed. Even if such concave portion is formed, a shape of the concave portion is made smooth. At that time, occurrence of the crack in the first organic layer 21 and the second organic layer 22 constituting the intermediate layer 20 may be suppressed. Since, a shape of the concave portion formed on the surface of the second organic layer 22 located on the opposing electrode 14 side becomes smooth, it can be suppressed that a part of the opposing electrode 14 becomes depressed into the second organic layer 22.. Thefefore, a short circuit between the opposing electrode 14 and the pixel electrode 16 may be suppressed. As a result, As a result, the solid state imaging device that generates less noise may be obtained.

In the solid state imaging device in the above example, the first organic layer 21 is the electron blocking layer. The first organic layer 21 is formed on the pixel electrodes 16 by vapor-depositing the organic material that is used to constitute the electron blocking layer, then the first organic layer 21 is annealed, and then the second organic layer 22 serving as the photoelectric conversion layer is formed. By doing this, the electron blocking layer capable of suppressing occurrence of the crack therein is formed, and a dark current is suppressed. Even when the first organic layer 21 and the second organic layer 22 are stacked sequentially and then the annealing is applied to these layers, a shape of the concave portion of the first organic layer 21 cannot be made smooth. Therefore, a shape of the concave portion is reflected on the surface of the second organic layer 22, and thus such a phenomenon is caused that the opposing electrode 14 formed on the second organic layer 22 becomes depressed into the concave portion on the second organic layer 22. As a result, the noise of the solid state imaging device is not reduced without fail.

In other words, when an inclination angle θ3 is defined with respect to the opposing electrode like the above, it is most preferable that a relation between θ3 and θ1 is equal to a relation between θ2 and θ1. When the opposing electrode is formed by the sputter, the depressing phenomenon of the opposing electrode is observed remarkably, and the advantage of the present invention becomes significant.

Next, another mode of the method of manufacturing the photoelectric converter will be explained hereunder. FIGS.3A-3C are also referred to hereunder to make an explanation. In this mode, the pixel electrodes 16 are formed in predetermined patterns on the insulating layer 12, and then the substrate 11 is heated at a time when the first organic layer 21 is vapor-deposited on the pixel electrodes 16. At this time, both temperatures of the pixel electrodes 16, on which the first organic layer 21 is vapor-deposited, and the surfaces 12A of the insulating layer 12, each of which is formed on the step portion 16G, are maintained within a range from 150 °C to a glass transition temperature of the step portion 16G by heating the substrate 11. In this way, the heating process of the substrate 11 and the annealing process of the first organic layer 21 are carried out simultaneously with the process that is applied to vapor-deposit the organic material constituting the first organic layer 21. By doing so, the step of vapor-depositing the first organic layer 21 and the step of annealing the first organic layer 21 can be done by one step, and a time required for the manufacture of the photoelectric converter is shortened. In this case, like the above, it is most preferable that the first organic layer 21 is formed as the electric charge blocking layer (in the example in FIGS.3A-3C, the electron blocking layer).

Next, respective preferable shapes of the step portion between the pixel electrodes and the concave portion on the first organic layer will be explained hereunder.

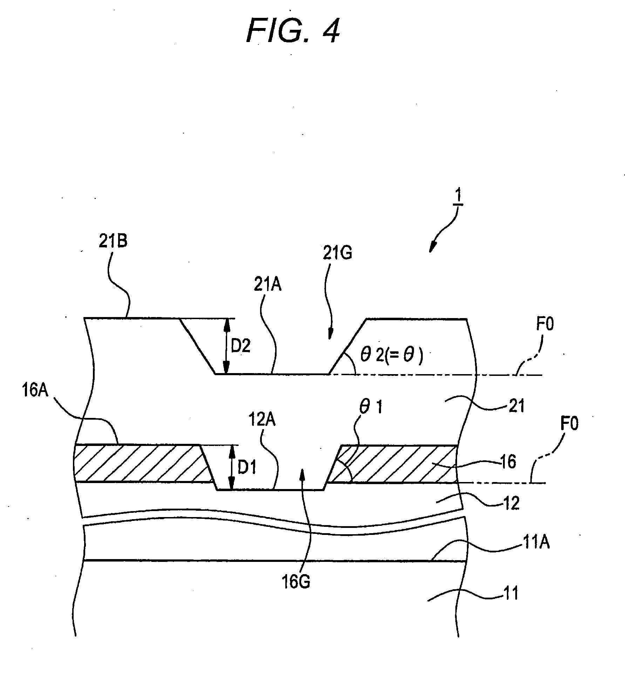

FIG.4 is a schematic sectional view showing respective shapes of the step portion between the pixel electrodes and the concave portion of the first organic layer in the photoelectric converter.

In FIG.4, the line F0 virtually indicates a plane that is parallel to the surface 11A of the substrate 11. Here, an inclination angle of the tangential plane to the surface 11A of the substrate 11 at a given point on the step portion 16G between the pixel electrodes 16 is assumed as θ1, and an inclination angle of the tangential plane to the surface of the substrate 11 at the given point on the concave portion 21G of the first organic layer 21 is defined as θ2. Respective definitions of the tangential plane and the inclination angle are similar to those described above.

Next, a rate of the number of white defect pixels to an inclination angle θ2 is measured.

In this measurement, a rate of the number of white defect pixels is a rate of the numbers of pixel portions, in which the white defect occurs, to the number of all pixel portions when the image taken by the imaging device is displayed. The imaging device used in the measurement is equipped with the photoelectric converter that has the same configuration as that of the photoelectric converter shown in FIG.1 and FIG.2. Hence, the configuration of the photoelectric converter shown in FIG.1 and FIG.2 will be referred to appropriately in the following explanation.

Also, except that the steps are not particularly mentioned in the following explanation, manufacturing steps of the photoelectric converter will be executed based on the same procedures as those described in above FIGS.3A-3C. Namely, as the steps of manufacturing the photoelectric converter, a plurality of pixel electrodes 16 were formed in patterns on the insulating layer 12 formed on the substrate 11, and then the organic material constituting the first organic layer 21 was vapor- deposited to cover a plurality of pixel electrodes 16 and the step portions 16G formed between the pixel electrodes 16. The deposited first organic layer 21 was annealed by the heating, and then a shape of the step portion 16G between the pixel electrodes 16 and a shape of the concave portion 21 G of the first organic layer 21 were measured. Then, the second organic layer 22, the opposing electrode 14, and other members were formed on the first organic layer 21 under the same conditions, and thus the imaging device was obtained. The number of white defect pixels was measured by using the resultant imaging device.

The pixel electrodes 16 are formed on the substrate 11 such that a pixel size is set to 3 µm, a gap between pixels is set to 0.3 µm, and a thickness is set to 30 nm. As the material of the pixel electrodes 16, TiN is employed. The step portion 16G is formed between the pixel electrodes 16 by the over-etching to have a depth of 10 nm. Therefore, the depth D 1 of the step portion 16G is set to 30 nm. Also, the inclination angle θ1 is set to 90 °.

Here, the depth D 1 of the step portion 16G of the pixel electrode 16 and the inclination angle θ1 of the step portion 16G can be set appropriately by the means, an example of which is given hereunder, while the pixel electrodes 16 are formed. The depth D1 of the step portion 16G of the pixel electrode 16 can be adjusted by a film thickness when the film for use in the pixel electrodes is formed. The inclination angle θ1 of the step portion 16G can be adjusted by a bias intensity in the etching.

In forming the first organic layer 21, such first organic layer 21 was vapor-deposited on the substrate 11 by the vacuum vapor deposition method.

The first organic layer 21 was formed by vapor-depositing the compound given by Formula (1) to have a thickness of 100 nm. As the result measured by using the local heating system "nano-TA2" manufactured by Anasys Instruments, as described above, a glass transition temperature of the compound given by Formula (1) was given as 161 °C. After the first organic layer 21 was formed, this first organic layer 21 was annealed in an inert atmosphere at a temperature of 90 °C to 135 °C for a time of 3 minutes to 2 hours such that the concave portion 21G was adjusted to have a predetermined inclination angle (2). Also, the compound given by Formula (2) and the fullerene c60 were vapor- deposited together such that a composition of the fullerene c60 becomes 80 %, and thus the second organic layer 22 (the photoelectric conversion layer) were formed to have a thickness of 400 nm.

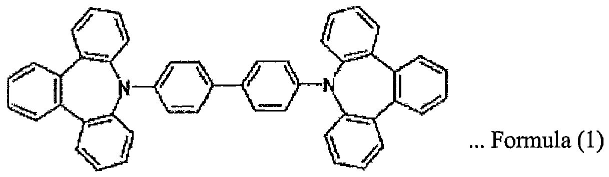

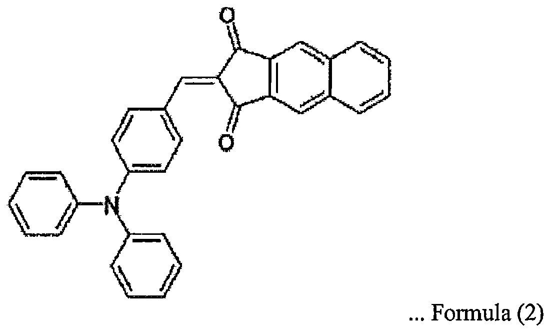

Also, the opposing electrode 14 was formed on the second organic layer 22 to have a thickness of 10 nm.

The results of this measurement are summarized in the following table.

**[Table 1]**

| Inclination angle (θ2) | Rte of the number of white defect pixels (%) | Decision |
|---|---|---|
| 2 | 0.00001 | ○ |
| 20 | 0.00002 | ○ |
| 40 | 0.003 | ○ |
| 50 | 0.008 | ○ |
| 60 | 0.04 | × |
| 65 | 0.1 | × |

As the decision of the measured result, the imaging device whose rate of the number of white defect pixels is less than 0.01 % is decided good and is indicated by "○", and the imaging device whose rate of the number of white defect pixels is more than 0.01 % is decided bad and is indicated by "×". The inclination angle is evaluated based on the TEM section image.

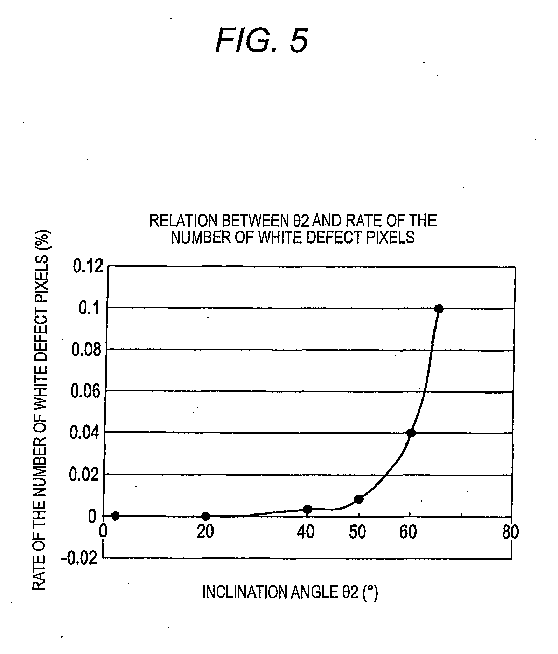

FIG.5 is a graph showing a relation between the inclination angle θ2 and a rate of the number of white defect pixels. It was found that, when the inclination angle θ2 of the photoelectric converter is 50 ° or less, the number of white defect pixels was reduced, and also the noise was suppressed.

Then, in the photoelectric converter of the present invention, the following measurement was executed to check a range of a preferable molecular weight of the organic layer. In this measurement, like the above, the photoelectric converter was manufactured by using the compounds given by Formulae (3) to (14) as well as Formula (1) as the first organic layer 21, then an annealing temperature was adjusted such that the inclination angle θ2 becomes substantially 0 °, and then the inclination angle and the rate of the number of white defect pixels at that time were measured.

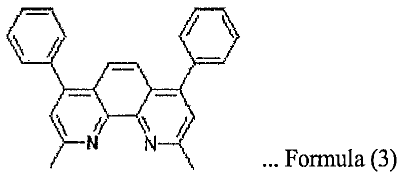

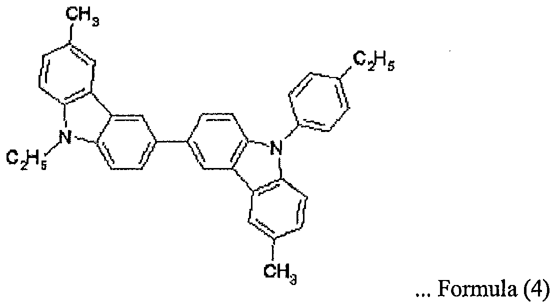

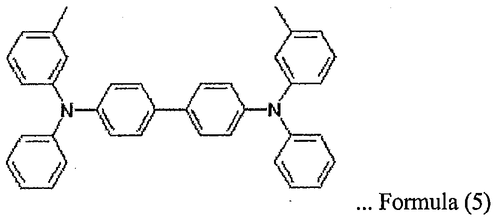

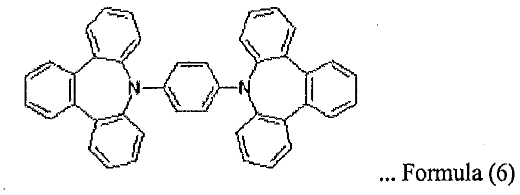

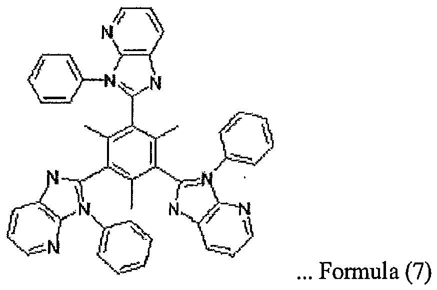

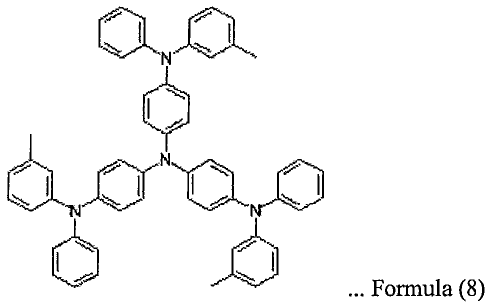

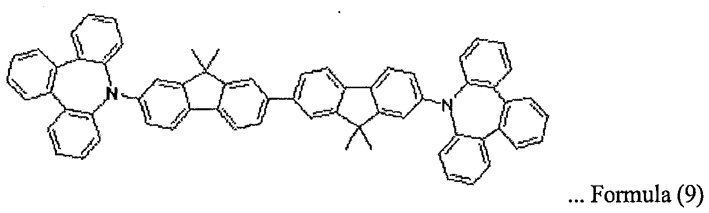

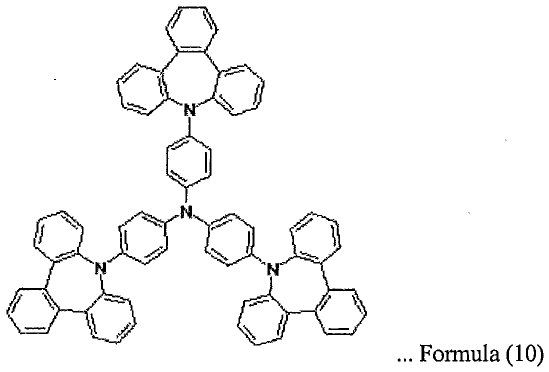

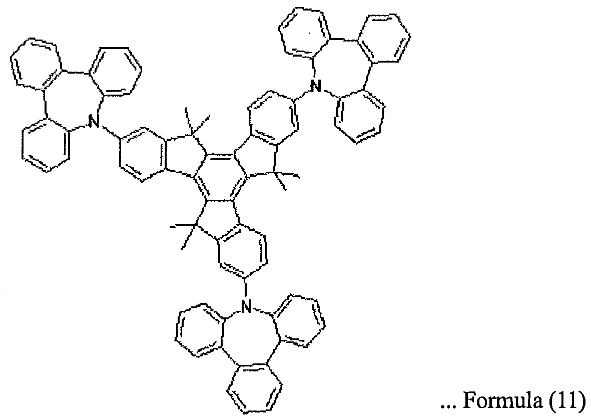

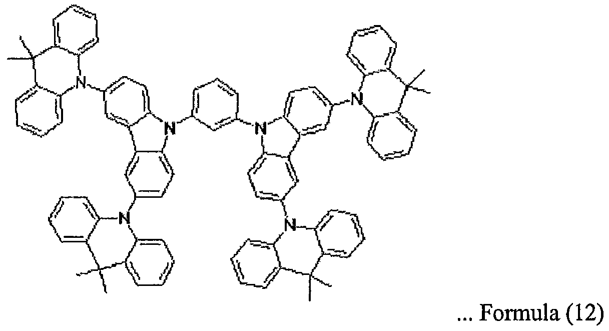

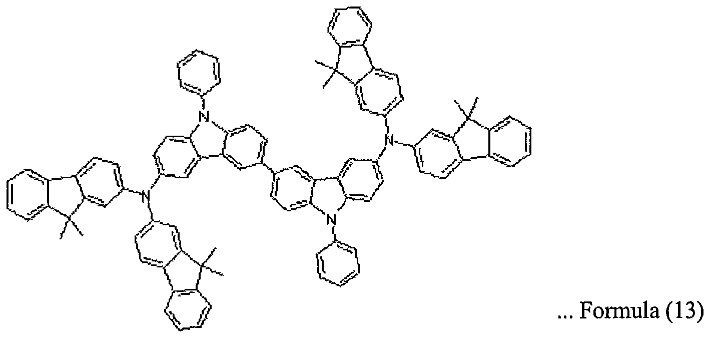

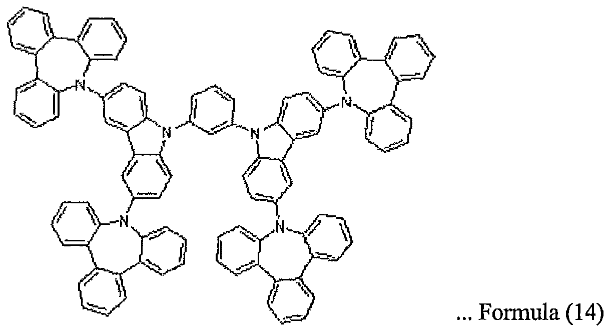

The results of this measurement are given in the following table.

**[Table 2]**

| Molecular weight | Organic layer inclination angle (°) | Rate of the number of white defect pixels (%) |
|---|---|---|
| 360 | 80 | 3 |
| 492 | 75 | 1.5 |
| 516 | 60 | 0.04 |
| 560 | 35 | 0.006 |
| 636 | 2 | 0.00002 |
| 705 | 5 | 0.00004 |
| 788 | 2 | 0.00002 |
| 868 | 5 | 0.00005 |
| 1000 | 2 | 0.00001 |
| 1149 | 2 | 0.00002 |
| 1236 | 45 | 0.006 |
| 1282 | 65 | 0.1 |
| 1372 | 85 | 5 |

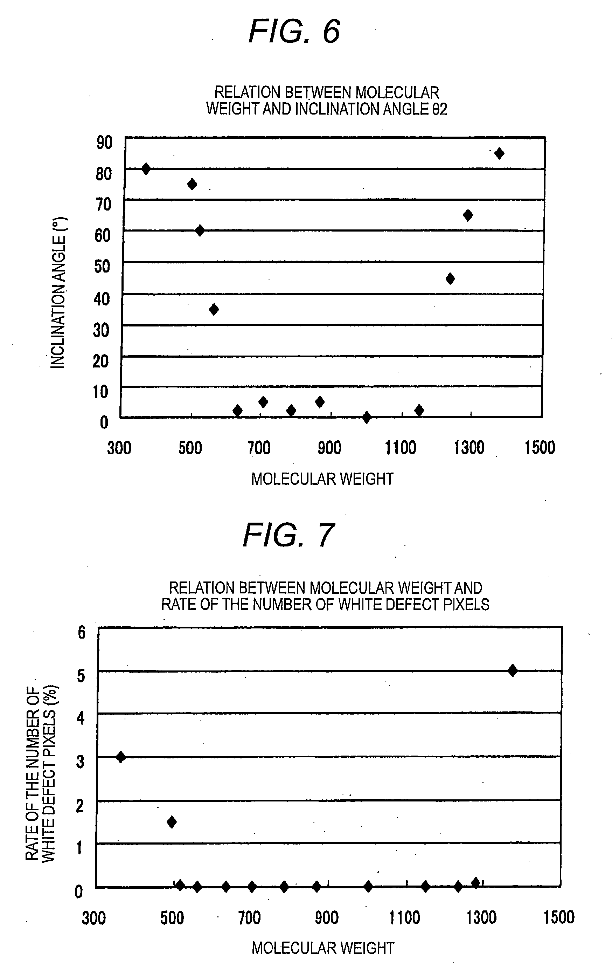

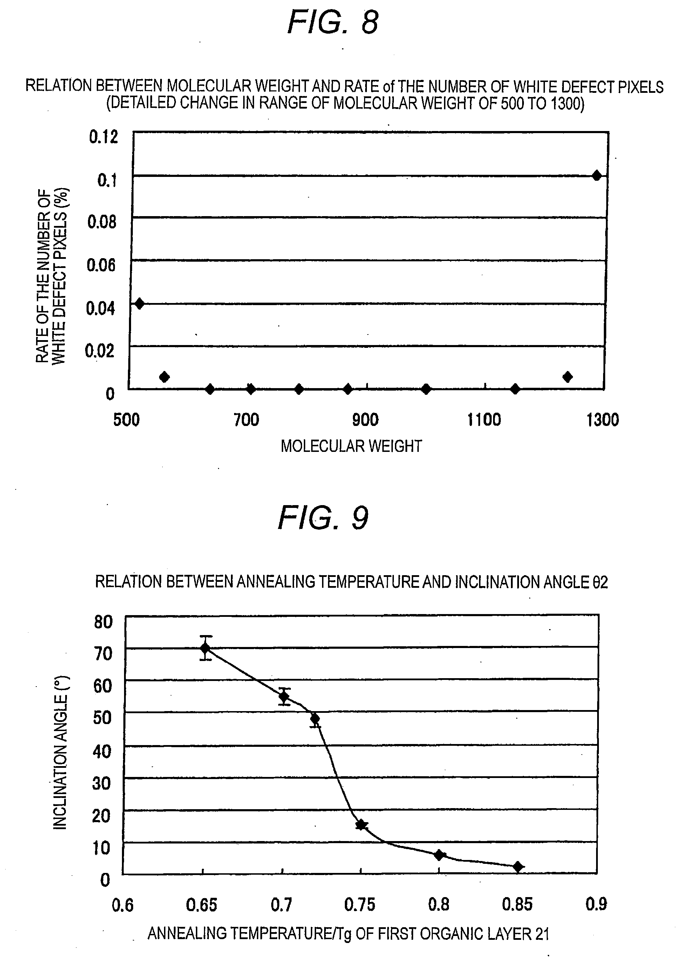

FIG6 is a graph showing a relation between a molecular weight and an inclination angle (θ2) of the material of the first organic layer 21. FIG.7 is a graph showing a relation between a molecular weight and a rate of the number of white defect pixels of the material of the first organic layer 21. FIG.8 is a graph showing a relation between a molecular weight and a rate of the number of white defect pixels of the material of the first organic layer 21, and showing in detail a change in the rate of the number of white defect pixels when the molecular weight ranges from 500 to 1300.

The results are summarized in the following table.

**[Table 3]**

| | Molecular weight | Lowest inclination (°) | Rate of the number of white defect pixels (%) | Decision |
|---|---|---|---|---|
| Example 1 | more than 550 but below 630 | 0 - 50 | 0 - 0.01 | ○ |
| Example 2 | more than 630 but below 1150 | 0 - 5 | 0 - 0.00005 | ○ |
| Example 3 | more than 1150 but below 1250 | 0 - 50 | 0 - 0.01 | ○ |
| Comparative Example 1 | below 550 | >50 | >0.01 | × |
| Comparative Example 2 | more than 1250 | >50 | >0.01 | × |

As the decision of the measured result, the imaging device whose rate of the number of white defect pixels is less than 0.01 % is decided good and is indicated by "○", and the imaging device whose rate of the number of white defect pixels is more than 0.01 % is decided bad and is indicated by "×".

### (Example 1)

In a range of the molecular weight of more than 550 but below 630, the inclination angle was suppressed less than 50 °, and also the number of white defect pixels was reduced below 0.01. However, the inclination angle was not suppressed substantially to 0 °. The reason for this may be considered that the organic layer has been crystallized while the inclination angle is changing from 50 ° to 0 °.

### (Example 2)

In a range of the molecular weight of more than 630 but below 1150, the inclination angle was suppressed substantially to 0 °, and also the number of white defect pixels was reduced below 0.01.

### (Example 3)

In a range of the molecular weight of more than 1100 but below 1250, the inclination angle was suppressed to less than 50 °, and also the number of white defect pixels was reduced below 0.01. However, the inclination angle was not suppressed substantially to 0 °. The reason for this may be considered such that the molecules are hard to move because the molecular weight is large.

### (Comparative Example 1)

In a range of the molecular weight of below 550, the inclination angle was not suppressed less than 50 °, and also the number of white defect pixels was not reduced below 0.01. The reason for this may be considered that the organic layer has been crystallized before the inclination angle is suppressed to less than 50 °.

### (Comparative Example 2)

In a range of the molecular weight of more than 1250, the inclination angle was not suppressed less than 50 °, and also the number of white defect pixels was not reduced below 0.01. The reason for this may be considered that the molecules are hard to move because the molecular weight is large.

With the above, it was found that preferably the molecular weight of the material of the first organic layer 21 was set to more than 550 but below 1250. More preferably, such molecular weight was set to more than 630 but below 1150.

Next, in the photoelectric converter of the present invention, following measurement was executed to check a desirable range of the annealing temperature. In this measurement, out of the compounds given by Formula (1) and Formulae (3) to (14), the compound whose molecular weight of which was more than 630 but below 1150 was selected as the material of the first organic layer 21, then the imaging device was manufactured, and then the inclination angle and the rate of the number of white defect pixels were measured when the annealing temperature is changed. The annealing time was set to 30 minute.

The results of this measurement are given in the following table.

**[Table 4]**

| Annealing Temperature/Tg | Inclination angle (°) | Rate of the number of white defect pixels (%) | Decision |
|---|---|---|---|
| 0.85 | 2 | 0.00001 | ○ |
| 0.8 | 6 | 0.00002 | ○ |
| 0.75 | 15 | 0.00002 | ○ |
| 0.72 | 48 | 0.008 | ○ |
| 0.7 | 55 | 0.02 | × |
| 0.65 | 70 | 0.15 | × |

As the decision of the measured result, the imaging device whose rate of the number of white defect pixels is less than 0.01 % is decided good and is indicated by "○", and the imaging device whose rate of the number of white defect pixels is more than 0.01 % is decided bad and is indicated by "×".

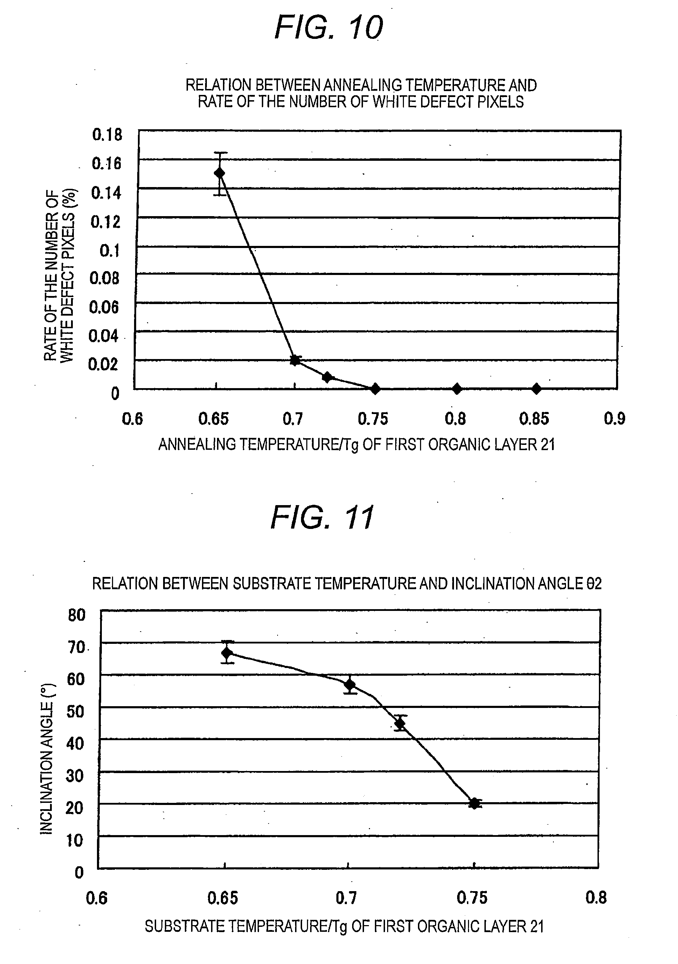

FIG.9 is a graph showing a relation between an annealing temperature/Tg and an inclination angle (θ2). FIG.10 is a graph showing a relation between the annealing temperature/Tg and the rate of the number of white defect pixels. It was found that, when the annealing temperature is in excess of Tg×0.72, the inclination angle of the photoelectric converter can be suppressed less than 50 °, the number of white defect pixels can be reduced, and the noise can be suppressed.

Next, in the photoelectric converter of the present invention, following measurement was executed to check a desirable range of the substrate temperature when the first organic layer 21 is manufactured by the substrate heating vapor deposition. In this measurement, the molecular weight of the material of the first organic layer 21 is set to more than 630 but below 1150, then the imaging device is manufactured, and then the inclination angle and the rate of the number of white defect pixels are measured when the substrate temperature is changed.

The results of this measurement are given in the following table.

**[Table 5]**

| Substrate Temperature/Tg | Inclination angle (°) | Rate of the number of white defect pixels (%) | Decision |
|---|---|---|---|
| 0.75 | 20 | 0.00002 | ○ |
| 0.72 | 45 | 0.006 | ○ |
| 0.7 | 57 | 0.03 | × |
| 0.65 | 67 | 0.15 | × |

As the decision of the measured result, the imaging device whose rate of the number of white defect pixels is less than 0.01 % is decided good and is indicated by "○", and the imaging device whose rate of the number of white defect pixels is more than 0.01 % is decided bad and is indicated by "×".

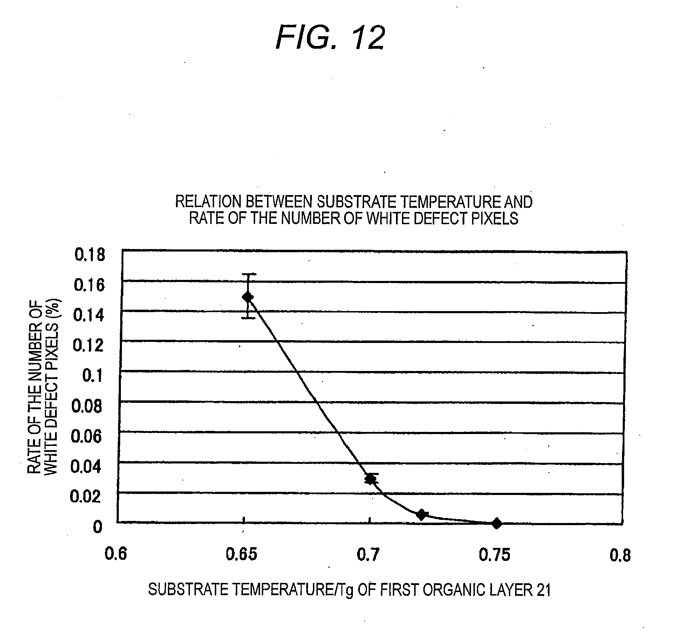

FIG.11 is a graph showing a relation between a substrate temperature/Tg and an inclination angle (θ2). FIG.12 is a graph showing a relation between the substrate temperature/Tg and the rate of the number of white defect pixels. It was found that, when the substrate temperature is in excess of Tg×0.72, the inclination angle of the photoelectric converter was suppressed less than 50 °, the number of white defect pixels was reduced, and the noise can be suppressed.

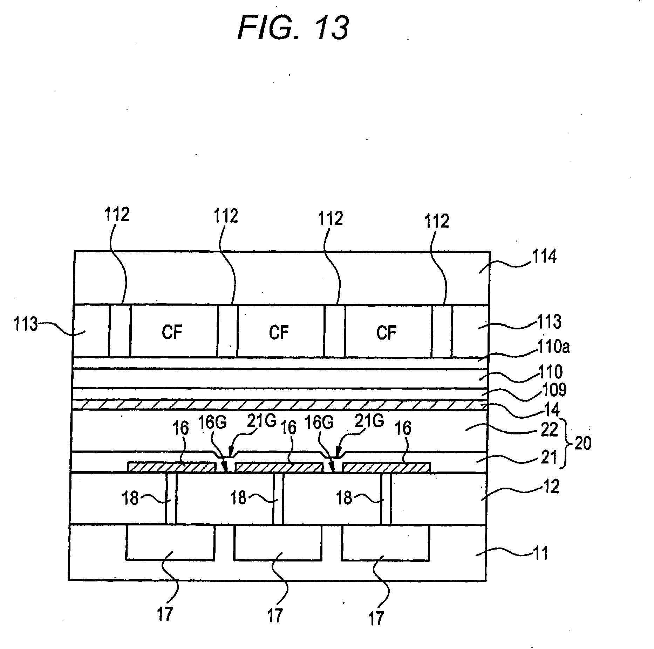

Next, an example of the configuration of the imaging device will be explained hereunder. FIG 13 is a schematic sectional view showing an example of the configuration of the imaging device. The imaging device in FIG. 13 is equipped with the substrate 11, the signal reading portions 17, the insulating layer 12, the connection portions 18, the pixel electrodes 16, the intermediate layer 20 having the first organic layer 21 and the second organic layer 22, and the opposing electrode 14, and these portions are similar to those mentioned above.

Also, in the imaging device, a buffer layer 109, a passivation layer 110, and a sealing assist layer 110a are stacked in this sequence on the opposing electrode 14. Also, color filters CF arranged over the pixel portions respectively, partitions 112 each of which isolates the adjacent color filters CF mutually, and an ambient light shielding layer 113 formed to cover upper portions of the areas where the pixel portion is not formed respectively are formed on the sealing assist layer 110a. The color filters CF, the partitions 112, and the ambient light shielding layer 113 are formed over the substrate 11 respectively to form the same layer level. Also, an overcoat layer 114 is formed to cover the color filters CF, the partitions 112, and the ambient light shielding layer 113. Further, a microlens may be formed on the overcoat layer 114.

In order to prevent a situation that the degradation of the photoelectric converting material contained in the photoelectric conversion layer is caused because the factors such as water molecules, etc. enter into the photoelectric conversion layer in the manufacturing steps, the buffer layer 109 has a function of adsorbing the factors or reacting with the factors.

The passivation layer 110 prevents that the factors such as the water molecules, etc., which cause the degradation of the photoelectric converting material, enter into the photoelectric conversion layer. The sealing assist layer 110a prevents such a situation that the factors that cannot be excluded by the passivation layer 110 enter into the photoelectric converting material.

The overcoat layer 114 protects the color filters CF from the post processes. The overcoat layer 114 is also referred to as the protection layer.

In the present specification, following matters are disclosed.
(1) A photoelectric converter, comprising:
   a pair of electrodes that is provided above a substrate; and
   a plurality of organic layers that is interposed between the pair of electrodes and includes a photoelectric conversion layer and a given organic layer being formed on one electrode of the pair of electrodes, the one electrode is one of pixel electrodes arranged two-dimensionally,
   wherein the given organic layer has a concave portion that is formed in a corresponding position located above a step portion among the arranged pixel electrodes, and
   an angle θ of the concave portion is less than 50°, where an inclination angle of a tangent plane at a given point on the concave portion to a surface plane of the substrate is defined as θ.
(2) The photoelectric converter according to (1), wherein the given organic layer is formed by a physical vapor deposition method, and is annealed after the given organic layer is formed.
(3) The photoelectric converter according to (1) or (2), wherein the given organic layer is formed by a vacuum heating vapor deposition method, and is annealed after the given organic layer is formed.
(4) A photoelectric converter according to any one of (1) to (3), wherein a molecular weight of the given organic layer is within a range of 550 to 1250.
(5) A photoelectric converter according to any one of (1) to (4), wherein the given organic layer is an electron blocking layer.
(6) A photoelectric converter according to any one of (1) to (5), wherein the other electrode is a common electrode.
(7) A method of manufacturing a photoelectric converter that includes:
   a pair of electrodes that is provided above a substrate; and
   a plurality of organic layers that is interposed between the pair of electrodes and includes a photoelectric conversion layer and a given organic layer being formed on one electrode of the pair of electrodes, the one electrode is one of pixel electrodes arranged two-dimensionally,
   the method, comprising:
      forming an insulating layer on the substrate;
      forming a pattern of the plurality of pixel electrodes on the insulating layer;
      forming the organic layer to cover the plurality of pixel electrodes; and
      annealing the organic layer by applying heating such that a shape of the concave portion formed on the organic layer in a corresponding position located above a step portion among the pixel electrodes is made smooth, before another organic layer is formed on the organic layer.
(8) The method according to (7), wherein the organic layer is formed by a physical vapor deposition method, and is annealed after the organic layer is formed.
(9) The method according to (7) or (8), wherein the organic layer is formed by a vacuum heating vapor deposition method, and is annealed after the organic layer is formed.
(10) The method according to any one of (7) to (9), wherein the substrate is heated when the organic layer is formed.
(11) The method according to any one of (7) to (10), wherein a temperature at which the organic layer is annealed is more than 0.72 × a glass transition temperature of the organic layer but less than the glass transition temperature of the organic layer.
(12) An imaging device comprising:
   a plurality of pixel portions that are arranged in an array fashion, each of the pixel portions including the photoelectric converter according to any one of claims 1 to 4, and
   a signal reading portion that read out a signal corresponding to electric charges generated by the photoelectric converter.

### [Designation of Reference Numerals]

- 1: imaging device
- 11: substrate
- 12: insulating layer
- 14: opposing electrode
- 16: pixel electrode
- 20: intermediate layer
- 21: first organic layer
- 22: second organic layer

## Claims

1. A photoelectric converter, comprising:
a pair of electrodes that is provided above a substrate; and
a plurality of organic layers that is interposed between the pair of electrodes and includes a photoelectric conversion layer and a given organic layer being formed on one electrode of the pair of electrodes, the one electrode is one of pixel electrodes arranged two-dimensionally,
wherein the given organic layer has a concave portion that is formed in a corresponding position located above a step portion among the arranged pixel electrodes, and
an angle θ of the concave portion is less than 50°, where an inclination angle of a tangent plane at a given point on the concave portion to a surface plane of the substrate is defined as θ.

2. The photoelectric converter according to claim 1, wherein the given organic layer is formed by a physical vapor deposition method, and is annealed after the given organic layer is formed.

3. The photoelectric converter according to claim 1 or 2, wherein the given organic layer is formed by a vacuum heating vapor deposition method, and is annealed after the given organic layer is formed.

4. A photoelectric converter according to any one of claims 1 to 3, wherein a molecular weight of the given organic layer is within a range of 550 to 1250.

5. A photoelectric converter according to any one of claims 1 to 4, wherein the given organic layer is an electron blocking layer.

6. A photoelectric converter according to any one of claims 1 to 5, wherein the other electrode is a common electrode.

7. A method of manufacturing a photoelectric converter that includes:
a pair of electrodes that is provided above a substrate; and
a plurality of organic layers that is interposed between the pair of electrodes and includes a photoelectric conversion layer and a given organic layer being formed on one electrode of the pair of electrodes, the one electrode is one of pixel electrodes arranged two-dimensionally,
the method, comprising:
forming an insulating layer on the substrate;
forming a pattern of the plurality of pixel electrodes on the insulating layer;
forming the organic layer to cover the plurality of pixel electrodes; and
annealing the organic layer by applying heating such that a shape of the concave portion formed on the organic layer in a corresponding position located above a step portion among the pixel electrodes is made smooth, before another organic layer is formed on the organic layer.

8. The method according to claim 7, wherein the organic layer is formed by a physical vapor deposition method, and is annealed after the organic layer is formed.

9. The method according to claim 7 or 8, wherein the organic layer is formed by a vacuum heating vapor deposition method, and is annealed after the organic layer is formed.

10. The method according to any one of claims 7 to 9, wherein the substrate is heated when the organic layer is formed.

11. The method according to any one of claims 7 to 10, wherein a temperature at which the organic layer is annealed is more than 0.72 × a glass transition temperature of the organic layer but less than the glass transition temperature of the organic layer.

12. An imaging device comprising:
a plurality of pixel portions that are arranged in an array fashion, each of the pixel portions including the photoelectric converter according to any one of claims 1 to 4, and
a signal reading portion that read out a signal corresponding to electric charges generated by the photoelectric converter.
